# FASCICULE DE BREVET EUROPEEN

(11) **EP 1 502 300 B1**
(45) Date de publication et mention de la délivrance du brevet: **17.10.2007**
(21) Numéro de dépôt: 03749913.4
(22) Date de dépôt: 02.05.2003
(51) Int. Cl.: H01L 23/66, H01L 23/522

(54) **CIRCUIT ELECTRONIQUE COMPRENANT UN CONDENSATEUR ET AU MOINS UN COMPOSANT SEMICONDUCTEUR, ET PROCEDE DE CONCEPTION D'UN TEL CIRCUIT**
SCHALTUNG MIT EINEM KONDENSATOR UND MINDESTENS EINEM HALBLEITERBAUELEMENT UND ENTWURFSVERFAHREN DAFÜR
CIRCUIT COMPRISING A CAPACITOR AND AT LEAST ONE SEMICONDUCTOR COMPONENT, AND METHOD FOR DESIGNING SAME

(30) Priorité: 07.05.2002 FR 0205712
(43) Date de publication de la demande: 02.02.2005
(73) Titulaire: STMicroelectronics S.A., 92120 Montrouge (FR)
(72) Inventeur: CATHELIN, Andréa, 38190 Laval (FR); BERNARD, Christophe, 38640 Claix (FR); DELPECH, Philippe, 38240 Meylan (FR); TROADEC, Pierre, 38000 Grenoble (FR); SALAGER, Laurent, 38420 Domene (FR); GARNIER, Christophe, 38570 Theys (FR)
(74) Mandataire: Loisel, Bertrand
(86) Numéro de dépôt international: PCT/FR2003/001372
(87) Numéro de publication internationale: WO 2003/096420

(56) Documents cités:
- EP-A- 0 353 426
- US-A- 5 151 769
- US-A- 5 571 740
- US-A- 6 128 768
- US-A- 2001 020 713

## Description

La présente invention concerne un circuit électronique intégré comprenant au moins un condensateur. Elle concerne plus particulièrement un circuit intégré dans lequel le fonctionnement d'un condensateur est susceptible d'être perturbé par des composants semiconducteurs disposés à proximité du condensateur, ou réciproquement.

Des circuits électroniques destinés à de nombreuses applications comprennent des premiers condensateurs à armatures métalliques essentiellement planes, en plus d'autres composants semiconducteurs tels que des transistors, des diodes, des résistances ou, éventuellement, des seconds condensateurs d'un type différent des premiers condensateurs. Les armatures métalliques essentiellement planes qui constituent lesdits premiers condensateurs sont sensiblement parallèles à la surface du substrat et peuvent avoir des dimensions géométriques relativement importantes telles que, par exemple, environ 50 micromètres de côté. On désigne dans la suite par condensateurs lesdits premiers condensateurs à armatures métalliques essentiellement planes, étant entendu que des seconds condensateurs tels qu'introduits ci-dessus peuvent être présents parmi lesdits composants semiconducteurs.

Ces condensateurs peuvent être disposés sur la surface du substrat, à côté des composants semiconducteurs. On entend par « disposition des condensateurs à côté des composants semiconducteurs » une configuration dans laquelle une première partie de la surface du substrat porte les composants semiconducteurs, et une seconde partie de la même surface du substrat, distincte de la première partie, porte les condensateurs. La surface du substrat occupée par le circuit présente alors une taille importante. Le coût du circuit électronique est alors élevé.

Une autre configuration possible consiste à disposer les condensateurs au dessus des composants semiconducteurs élaborés à la surface du substrat, au sein de couches de matériaux isolants qui recouvrent la surface du substrat et les composants semiconducteurs. On entend par « disposition des condensateurs au dessus des composants semiconducteurs » une configuration dans laquelle les condensateurs sont superposés aux composants semiconducteurs au dessus à la surface du substrat qui les porte. Une importante économie de surface de substrat résulte de cette configuration par rapport à la configuration précédente, qui permet une réduction conséquente du prix des circuits électroniques correspondants.

On sait par ailleurs que des condensateurs de dimensions telles que celles citées plus haut sont particulièrement sensibles aux parasites électriques et/ou électromagnétiques. Ceci est notamment le cas dans des circuits électroniques dits «analogiques». On désigne par circuits «analogiques» des circuits électroniques qui fonctionnent avec des signaux correspondant à des fréquences inférieures à 10 mégahertz environ. On trouve par exemple de tels circuits dans des terminaux de communication mobile. Il s'agit notamment d'unités de gestion de puissance ou de circuits analogiques de traitement de signal tels que des filtres, des amplificateurs, des régulateurs, des comparateurs, etc. Lorsque les condensateurs sont disposés au dessus de composants semiconducteurs, ces derniers génèrent des parasites qui perturbent le fonctionnement des condensateurs. Réciproquement, les condensateurs peuvent aussi perturber le fonctionnement des composants au dessus desquels ils sont disposés. Ces perturbations sont liées aux distances réduites qui séparent les condensateurs des composants semiconducteurs lorsqu'ils sont superposés à ces derniers.

Le document US 2001/0020713 divulgue l'utilisation d'un écran conducteur continu, qui est situé entre un transistor MOS et un condensateur MIM au sein d'un circuit électronique intégré.

La présente invention est définie par le produit selon la revendication 1 et la méthode selon la revendication 11.

Grâce à la disposition de l'écran entre le condensateur et le composant semiconducteur, des parasites électroniques et/ou électromagnétiques émis par le composant semiconducteur sont arrêtés par l'écran. Ces parasites ne perturbent alors pas le fonctionnement du condensateur. Le même effet de protection est obtenu pour le fonctionnement du composant semiconducteur vis-à-vis de parasites produits par le condensateur.

Il est à noter que le condensateur et le composant semiconducteur sont dits appartenir au même circuit électronique en ce sens qu'ils sont portés par le même substrat. Néanmoins, il faut comprendre qu'ils peuvent appartenir chacun à des parties de circuit fonctionnellement différentes, reliées ou non entre elles, et que l'invention présente un intérêt lorsque des perturbations du fonctionnement de l'une au moins des parties de circuit peuvent résulter de la superposition du condensateur et du composant semiconducteur.

Afin d'obtenir une protection plus efficace du fonctionnement du condensateur, l'écran peut présenter des bords situés au moins partiellement à l'extérieur d'une projection de bords du condensateur dans un plan contenant l'écran, selon la direction perpendiculaire à la surface du substrat. De plus, les bords de l'écran peuvent être situés à au moins 2 micromètres de la projection des bords du condensateur, suivant une direction parallèle à la direction dudit plan contenant l'écran.

Symétriquement, en vue d'obtenir une protection plus efficace du fonctionnement du composant semiconducteur, les bords de l'écran peuvent être partiellement situés à l'extérieur d'une projection de bords du composant semiconducteur dans le plan contenant l'écran, selon la direction perpendiculaire à la surface du substrat. De même, les bords de l'écran peuvent aussi être situés à au moins 2 micromètres de la projection des bords du composant semiconducteur, suivant une direction parallèle à la direction dudit plan contenant l'écran.

Selon la nature des parasites contre lesquels l'écran est destiné à réaliser une protection, l'écran peut être avantageusement relié électriquement à une borne portée à un potentiel électrique déterminé.

Dans un mode de mise en oeuvre préféré de l'invention, le composant semiconducteur est disposé à proximité de la surface du substrat, et le circuit comprend plusieurs couches de matériaux isolants superposées qui recouvrent la surface du substrat et le composant semiconducteur. Le condensateur est disposé au sein d'au moins l'une des couches de matériau isolant au dessus du composant semiconducteur, c'est-à-dire d'un côté de celui-ci opposé au substrat. L'écran est alors disposé au sein d'au moins une couche de matériau isolant intermédiaire entre la surface du substrat et la (ou les) couche(s) de matériau isolant au sein de laquelle (desquelles) est disposé le condensateur.

Dans cette mise en oeuvre de l'invention, l'écran peut être disposé au sein d'une couche de matériau isolant adjacente (suivant la direction perpendiculaire à la surface du substrat) à la (ou aux) couche(s) au sein de laquelle (desquelles) est disposé le condensateur, d'un même côté de cette dernière couche que le substrat. En particulier, aucune partie de circuit électrique susceptible de perturber le fonctionnement du condensateur n'est intercalée entre l'écran et le condensateur.

Le circuit électronique peut néanmoins comprendre en outre des connexions métalliques ou des résistances disposées au sein de couches de matériaux isolants supplémentaires, parallèles à la surface du substrat. Dans ce cas, afin de préserver un fonctionnement non-perturbé du condensateur contre d'éventuels parasites produits par ces connexions métalliques ou ces résistances, au moins les connexions métalliques et les résistances venant au droit du condensateur sont avantageusement situées du côté de l'écran opposé au condensateur.

Un second aspect de l'invention concerne un procédé de conception d'un circuit électronique comprenant un condensateur et au moins un composant semiconducteur disposés selon l'agencement décrit précédemment, le procédé comprenant les étapes suivantes :
a) réalisation de prototypes comprenant chacun un substrat, un condensateur de mesure d'un type déterminé respectif, le condensateur de mesure étant porté par une surface du substrat, chaque prototype comprenant en outre un écran sensiblement plan et parallèle à la surface du substrat, l'écran étant constitué de matériau métallique et disposé au droit du condensateur de mesure selon une direction perpendiculaire à la surface du substrat ;
b) mesure de caractéristiques électriques respectives des condensateurs de mesure au sein des prototypes ;
c) exécution de simulations, au moyen d'au moins un logiciel de conception assistée de circuits électroniques, du fonctionnement du circuit électronique en utilisant certaines des caractéristiques électriques mesurées des condensateurs de mesure ;
d) sélection d'un type de condensateur en fonction des résultats des simulations ;
e) fabrication du circuit électronique avec un condensateur du type sélectionné.

Selon un mode d'exécution préféré du procédé, l'étape c) comprend elle-même une première étape c1) lors de laquelle on génère des modèles électriques associés aux condensateurs de mesure en utilisant les caractéristiques électriques mesurées, et une seconde étape c2) lors de laquelle on exécute les simulations en utilisant certains au moins des modèles électriques générés.

De façon analogue, un procédé de conception d'un circuit électronique selon l'invention peut être mis en oeuvre en utilisant des prototypes comprenant chacun un composant semiconducteur de mesure porté par une surface d'un substrat, et comprenant un écran sensiblement plan et parallèle à la surface du substrat, constitué de matériau métallique, et disposé au droit du composant semiconducteur de mesure. Le procédé comprend alors la réalisation de mesures de caractéristiques électriques des composants semiconducteurs de mesure au sein des prototypes respectifs. Des simulations, au moyen d'au moins un logiciel de conception assistée de circuits électroniques, d'un fonctionnement du circuit électronique sont alors exécutées en utilisant certaines des caractéristiques électriques mesurées des composants semiconducteurs de mesure, et un type de composant semiconducteur est sélectionné, en fonction des résultats des simulations, pour la fabrication du circuit électronique. De même que précédemment, des modèles électriques des composants semiconducteurs établis sur la base des caractéristiques électriques mesurées peuvent être utilisés comme éléments intermédiaires de simulation de fonctionnement du circuit électronique.

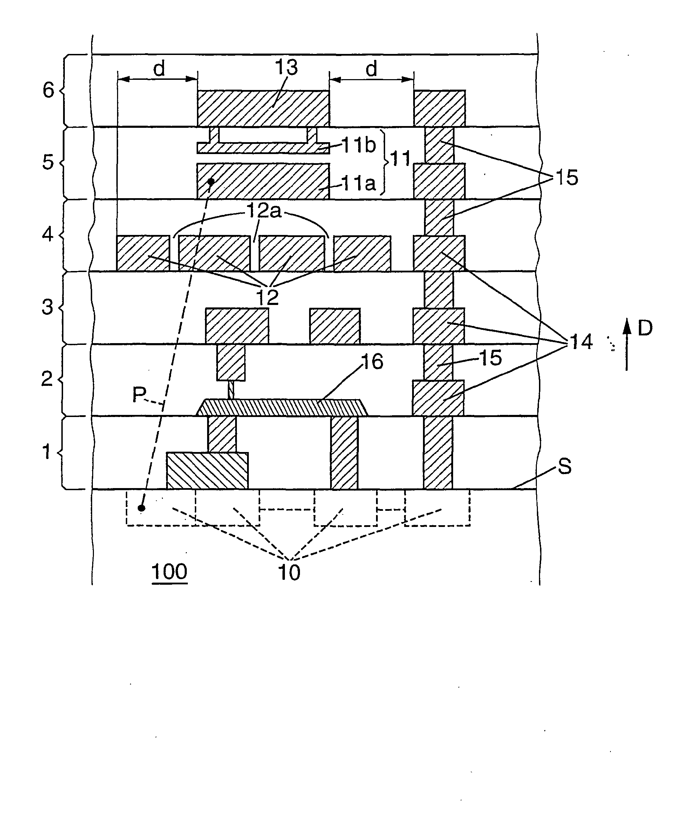

D'autres particularités et avantages de la présente invention apparaîtront dans la description ci-après d'un exemple de réalisation non limitatif, en référence à l'unique figure annexée.

La figure est une vue en coupe d'un circuit électronique élaboré selon l'invention.

A la figure, pour des raisons de clarté, les dimensions des différentes parties de composants représentées ne sont pas en proportion avec leurs dimensions réelles. On désigne par D une direction perpendiculaire à la surface du substrat. Cette direction D est orientée vers le haut de la figure, et les mots «sur», «sous», «inférieur» et «supérieur» utilisés dans la suite le sont en référence à cette orientation.

A titre d'exemple, un circuit électronique tirant un avantage particulier de l'invention fait partie d'un premier étage de circuits de traitement de signaux radio incorporés dans un terminal mobile de communication. Ce premier étage de circuits est communément désigné par «étage base-band». Il peut notamment s'agir d'un filtre, dont le schéma de fonctionnement électrique est connu de l'Homme du métier, et qui peut être conçu pour fonctionner alternativement en mode GSM/DCS ou en mode W-CDMA. Ce type de circuit analogique nécessite un comportement parfaitement linéaire et un niveau de bruits parasites très bas qui rendent l'utilisation de la présente invention particulièrement favorable. Par exemple, le circuit considéré incorpore des condensateurs à hauteur de capacités totales de 1,7 nanofarad et de 21,3 picofarads, pour les parties de circuit dédiées respectivement aux modes GSM/DCS et W-CDMA. Ces condensateurs sont réalisés selon la technologie dite «Métal-Isolant-Métal», ou MIM, qui permet d'obtenir une capacité de 2 femtofarad par micromètre-carré de surface d'armature. Selon cette technologie, les condensateurs possèdent des armatures planes disposées parallèlement à une surface d'un substrat sur lequel ils sont élaborés. Ainsi, les ensembles de condensateurs précédents correspondant à chacun des modes GSM/DCS et W-CDMA occupent des surfaces respectives de substrat d'environ 1,4 et 0,04 millimètre-carré. Il est donc particulièrement avantageux pour ce type de circuits électroniques de disposer ces condensateurs au dessus d'autres composants portés par le substrat, de façon à réduire les dimensions des substrats utilisés.

Conformément à la figure, des composants semiconducteurs 10, actifs ou passifs, sont élaborés au niveau d'une surface plane S d'un substrat de silicium 100. Ces composants semiconducteurs sont obtenus par des technologies usuelles de fabrication de composants tels que des transistors, notamment par les technologie bipolaire, CMOS («Complementary Metal-Oxide-Semiconductor») et BICMOS, cette dernière technologie associant entre eux des transistors des deux types bipolaire et CMOS. Ces technologies utilisées peuvent être notamment adaptées pour obtenir des dimensions caractéristiques de transistors (par exemple des largeurs de grille ou de base) inférieures à 0,35 micromètre.

Plusieurs couches de matériaux isolants, respectivement référencées 1-6, telles que des couches de silice SiO₂ ou de nitrure de silicium SiNₓ, sont superposées selon la direction D. Ces couches 1-6 comprennent des connexions métalliques qui sont, par exemple, des pistes 14 disposées parallèlement à la surface S et des connexions 15 permettant la circulation de courants électriques selon la direction D, appelées «vias» dans le jargon de l'Homme du métier. Ces connexions métalliques peuvent être élaborées en utilisant l'une des méthodes suivantes : la méthode classique de gravure du métal, par exemple lorsque le métal est de l'aluminium, la méthode Damascène ou la méthode «dual Damascène», pour lesquelles le métal peut être, en particulier, le cuivre.

Certaines de ces couches de matériaux isolants (couche 2 sur la figure) peuvent en outre incorporer des résistances 16, formées chacune d'un segment de matériau choisi pour son comportement ohmique, tel que, par exemple, du nitrure de tantale TaN.

Un condensateur 11, du type MIM introduit plus haut, est incorporé dans la couche 5 et situé au droit de certains des composants 10. Le condensateur 11 comprend une première armature 11a et une seconde armature 11b, planes et parallèles à la surface S (voir figure), et disposées en regard l'une de l'autre.

La couche supérieure 6 de matériau isolant, disposée au dessus de la couche 5, peut incorporer une piste 13 d'alimentation de l'armature supérieure 11b.

Selon l'invention, la couche 4 de matériau isolant incorpore un écran métallique 12 parallèle à la surface S. Le matériau de l'écran 12 peut être du cuivre, de l'aluminium, du tungstène, du tantale, ou un alliage comprenant au moins l'un des métaux précédents.

Pour garantir une protection efficace du fonctionnement du condensateur 11, les bords de l'écran 12 doivent être situés à l'extérieur d'une projection, selon la direction D, des bords du condensateur 11 dans un plan contenant l'écran 12. Il est en outre recommandé que les bords de l'écran 12 soient situés à au moins 2 micromètres de la projection des bords du condensateur 11 dans le plan contenant l'écran.

Dans l'exemple décrit ici, les dimensions de l'écran 12 dans un plan parallèle à la surface S sont choisies de façon à ce que l'écran 12 présente une surface périphérique de largeur d d'environ 10 micromètres s'étendant au delà du droit d'un contour du condensateur 11. Ainsi, l'écran 12 peut intercepter des parasites émis par l'un des composants semiconducteurs 10 en direction du condensateur 11 selon une direction P oblique par rapport à la direction D.

Si l'un des composants semiconducteurs 10 est particulièrement sensible à des parasites émis par le condensateur 11, les bords de l'écran 12 doivent alors aussi être situés à l'extérieur d'une projection de bords du composant semiconducteur sensible dans un plan contenant l'écran. Il est alors encore recommandé que les bords de l'écran 12 soient situés à au moins 2 micromètres de la projection des bords du composant semiconducteur sensible.

Sans réduire la capacité de protection du condensateur 11 par l'écran 12 contre des parasites émis par certains de composants semiconducteurs 10, l'écran comporte des ouvertures 12a. Ces ouvertures 12a, traversant l'écran 12 entre des faces inférieure et supérieure de cet écran 12, ont des largeurs respectives d'environ 1 micromètre, mesurées parallèlement à la surface S. Elles sont séparées entre elles d'environ 100 micromètres et permettent la diffusion d'atomes d'hydrogène au travers de l'écran 12 selon la direction D. De tels atomes d'hydrogène sont utilisés lors de la fabrication du circuit électronique, en particulier pour saturer des liaisons pendantes éventuellement présentes à l'interface entre des parties de matériau silicium et des parties de silice du circuit électronique.

Du fait de sa proximité avec l'écran 12, le condensateur 11, ainsi que, éventuellement, chacun des composants semiconducteurs 10, peut développer une interaction avec l'écran 12 qui altère son comportement électrique par rapport à une situation dans laquelle ce condensateur ou ce composant semiconducteur est considéré isolément. Cette interaction peut être de type influence capacitive, inductive ou autre, et peut être modélisée par un schéma électrique équivalent. Le schéma électrique équivalent est alors pris en compte dans la prévision du fonctionnement du circuit électronique afin de satisfaire le plus possible l'application pour laquelle le circuit électronique est destiné. En particulier, un type du condensateur 11 et/ou de chaque composant semiconducteur 10 peut être choisi en tenant compte de ce schéma électrique équivalent.

Dans une mise en oeuvre préférée de cette méthode de prise en compte de l'influence de l'écran sur le fonctionnement de chaque composant électronique, une bibliothèque de caractéristiques électriques de composants électroniques est constituée, dans laquelle chaque composant est considéré en présence d'un écran tel que décrit plus haut. Cette bibliothèque regroupe des caractéristiques de condensateurs pouvant être utilisés en tant que condensateur 11 dans le filtre «base band» précédent, et des caractéristiques de composants semiconducteurs pouvant être utilisés en tant que composants semiconducteurs 10. Des types de condensateurs et de composants semiconducteurs dont les caractéristiques électriques sont regroupées dans la bibliothèque sont distingués, par exemple, par leurs dimensions géométriques respectives, leurs formes, les matériaux qui les constituent, etc.

Pour chaque composant, de telles caractéristiques électriques sont obtenues par des mesures électriques effectuées sur au moins un prototype de ce composant élaboré avec un écran sur un substrat. Ces caractéristiques électriques sont ensuite introduites dans la bibliothèque en vue de leur exploitation ultérieure lors de la conception d'un circuit électronique. Ainsi, les caractéristiques électriques des composants contenues dans la bibliothèque prennent en compte l'influence de l'écran sur le fonctionnement de ces composants.

De façon connue, lors de la conception d'un circuit électronique, préalablement à la fabrication de ce circuit, un concepteur de circuits simule le fonctionnement du circuit au moyen d'un logiciel de conception assistée spécialement adapté. De tels logiciels de conception assistée utilisent des bibliothèques pré-établies de caractéristiques électriques de composants électroniques, et déterminent des caractéristiques du fonctionnement du circuit en calculant des réponses électriques des composants du circuit. En fonction de ces caractéristiques, le concepteur de circuits modifient des types de certains composants afin d'ajuster le fonctionnement du circuit par rapport à un cahier des charges prédéfini.

L'utilisation de caractéristiques électriques de composants établies en présence d'écrans permet de prendre en compte l'influence des écrans dans les simulations. Le fonctionnement ainsi simulé du circuit électronique concorde alors très exactement avec le fonctionnement réel du circuit. Lors de la simulation, le choix de types de composants en fonction des résultats des simulations permet une très bonne optimisation du fonctionnement du circuit par rapport à un cahier des charges.

Afin de permettre une prise en compte la plus exacte possible de l'influence de l'écran sur le fonctionnement du composant électronique, un type déterminé de configuration d'écran est fixé pour tous les prototypes de composants, et est repris pour l'écran 12 du circuit électronique fabriqué. Le choix d'un type unique de configuration d'écran permet d'éviter une déclinaison de chaque composant dans la bibliothèque en fonction du type de l'écran qui est mis en présence de ce composant. Le type de configuration de l'écran peut être défini par des caractéristiques communes d'écrans telles que, par exemple, des dimensions minimales d'écran dans un plan parallèle à la surface du substrat, une épaisseur d'écran, une résistivité électrique du matériau constitutif de l'écran, une distance de séparation entre l'écran et le composant électronique concerné, etc.

## Revendications

1. Circuit électronique comprenant un substrat (100), un condensateur (11) et au moins un composant semiconducteur (10) portés par une surface (S) du substrat, le condensateur et le composant semiconducteur étant disposés au droit l'un de l'autre selon une direction (D) perpendiculaire à la surface (S) du substrat, dans lequel un écran plan (12) et parallèle à la surface du substrat, constitué d'un matériau métallique, est disposé entre le condensateur et le composant semiconducteur,
le circuit étant **caractérisé en ce que** l'écran comporte des ouvertures (12a).

2. Circuit selon la revendication 1, dans lequel des bords de l'écran (12) sont au moins partiellement situés à l'extérieur d'une projection de bords du condensateur (11) dans un plan contenant l'écran, selon la direction (D) perpendiculaire à la surface du substrat.

3. Circuit selon la revendication 2, dans lequel les bords de l'écran sont situés à au moins 2 micromètres de la projection des bords du condensateur, suivant une direction parallèle à la direction dudit plan contenant l'écran.

4. Circuit selon l'une quelconque des revendications précédentes, dans lequel des bords de l'écran (12) sont au moins partiellement situés à l'extérieur d'une projection de bords du composant semiconducteur (10) dans un plan contenant l'écran, selon la direction (D) perpendiculaire à la surface du substrat.

5. Circuit selon la revendication 4, dans lequel les bords de l'écran sont situés à au moins 2 micromètres de la projection des bords du composant semiconducteur, suivant une direction parallèle à la direction dudit plan contenant l'écran.

6. Circuit selon l'une quelconque des revendication précédentes, dans lequel le composant semiconducteur (10) est disposé à proximité de la surface (S) du substrat (100), le circuit comprenant plusieurs couches de matériaux isolants superposées (1-6) qui recouvrent la surface du substrat et le composant semiconducteur, le condensateur étant disposé au sein d'au moins une couche (5) de matériau isolant au dessus du composant semiconducteur, et dans lequel l'écran (12) est disposé au sein d'au moins une couche (4) de matériau isolant intermédiaire entre la surface du substrat et la couche de matériau isolant au sein de laquelle est disposé le condensateur.

7. Circuit selon la revendication 6, dans lequel la couche (4) de matériau isolant au sein de laquelle est disposé l'écran (12) est adjacente à la couche (5) de matériau isolant au sein de laquelle est disposé le condensateur.

8. Circuit selon la revendication 6 ou la revendication 7, comprenant en outre des connexions métalliques (14, 15) ou des résistances (16) disposées au sein de couches de matériaux isolants supplémentaires (1-3) parallèles à la surface (S) du substrat, dans lequel au moins les connexions métalliques et les résistances venant au droit du condensateur sont situées du côté de l'écran (12) opposé au condensateur.

9. Circuit selon l'une quelconque des revendications précédentes, dans lequel l'écran (12) est relié électriquement à une borne portée à un potentiel électrique déterminé.

10. Circuit selon l'une quelconque des revendications précédentes, dans lequel le matériau de l'écran (12) est choisi parmi une liste de métaux comprenant le cuivre, l'aluminium, le tungstène, le tantale, et un alliage comprenant au moins l'un des métaux précédents.

11. Procédé de conception d'un circuit électronique selon l'une quelconque des revendications 1 à 10, comprenant les étapes suivantes :
a) réalisation de prototypes comprenant chacun un substrat, un condensateur de mesure ou un composant semiconducteur de mesure d'un type déterminé respectif, le condensateur de mesure ou le composant semiconducteur de mesure étant porté par une surface du substrat, chaque prototype comprenant en outre un écran plan et parallèle à la surface du substrat, l'écran étant constitué de matériau métallique comportant des ouvertures (12a) et disposé au droit du condensateur de mesure ou du composant semiconducteur de mesure selon une direction perpendiculaire à la surface du substrat ;
b) mesure de caractéristiques électriques respectives des condensateurs de mesure ou des composants semiconducteurs de mesure au sein des prototypes ;
c) exécution de simulations, au moyen d'au moins un logiciel de conception assistée de circuits électroniques, du fonctionnement du circuit électronique en utilisant certaines des caractéristiques électriques mesurées des condensateurs de mesure ou des composants semiconducteurs de mesure ;
d) sélection d'un type de condensateur ou de composant semiconducteur en fonction des résultats des simulations ; et
e) fabrication du circuit électronique avec un condensateur (11) ou un composant semiconducteur (10) du type sélectionné.

12. Procédé selon la revendication 11, dans lequel l'étape c) comprend les étapes suivantes :
c1) génération de modèles électriques associés aux condensateurs de mesure ou aux composants semiconducteurs de mesure en utilisant les caractéristiques électriques mesurées ; et
c2) exécution de simulations en utilisant certains au moins des modèles électriques générés.

## Claims

1. Electronic circuit comprising a substrate (100), a capacitor (11) and at least one semiconductor component (10) which are supported by a surface (S) of the substrate, the capacitor and the semiconductor component being placed in line with each other along a direction (D) perpendicular to the surface (S) of the substrate, in which circuit a planar screen (12) parallel to the surface of the substrate, made of a metallic material, is arranged between the capacitor and the semiconductor component,
the circuit being **characterized in that** the screen has apertures (12a).

2. Circuit according to Claim 1, wherein edges of the screen (12) are at least partially located outside a projection of edges of the capacitor (11) in a plane containing the screen, along the direction (D) perpendicular to the surface of the substrate.

3. Circuit according to Claim 2, wherein the edges of the screen are located at least 2 microns from the projection of the edges of the capacitor, along a direction parallel to the direction of said plane containing the screen.

4. Circuit according to any one of the preceding claims, wherein edges of the screen (12) are at least partially located outside a projection of the edges of the semiconductor component (10) in a plane containing the screen, along the direction (D) perpendicular to the surface of the substrate.

5. Circuit according to Claim 4, wherein the edges of the screen are located at least 2 microns from the projection of the edges of the semiconductor component, along a direction parallel to the direction of said plane containing the screen.

6. Circuit according to any one of the preceding claims, wherein the semiconductor component (10) is arranged in proximity to the surface (S) of the substrate (100), the circuit comprising several superposed layers (1-6) of insulating material which cover the surface of the substrate and the semiconductor component, the capacitor being arranged within at least one layer (5) of insulating material above the semiconductor component, and wherein the screen (12) is arranged within at least one intermediate layer (4) of insulating material between the surface of the substrate and the layer of insulating material within which the capacitor is placed.

7. Circuit according to Claim 6, wherein the layer (4) of insulating material, within which the screen (12) is arranged, is adjacent to the layer (5) of insulating material within which the capacitor is arranged.

8. Circuit according to Claim 6 or Claim 7, which furthermore includes metallic connections (14, 15) or resistors (16) arranged within additional layers (1-3) of insulating material parallel to the surface (S) of the substrate, wherein at least the metallic connections and the resistors in line with the capacitor are located on the opposite side of the screen (12) to the capacitor.

9. Circuit according to any one of the preceding claims, wherein the screen (12) is electrically connected to a terminal raised to a defined electrical potential.

10. Circuit according to any one of the preceding claims, wherein the material of the screen (12) is chosen from a list of metals comprising copper, aluminium, tungsten, tantalum, and an alloy containing at least one of the above metals.

11. Method of designing an electronic circuit according to any one of Claims 1 to 10, comprising the following steps:
a) producting prototypes each comprising a substrate, a measurement capacitor or a measurement semiconductor component of a respective defined type, the measurement capacitor or the measurement semiconductor being supported by a surface of the substrate, each prototype furthermore including a substantially planar screen parallel to the surface of the substrate, the screen being made of metallic material having apertures (12a) and arranged in line with the measurement capacitor or the measurement semiconductor component along a direction perpendicular to the surface of the substrate;
b) measuring respective electrical characteristics of the measurement capacitors or of the measurement semiconductor components within the prototypes;
c) performing simulations, by means of at least one computer-aided design software package for electronic circuits, of the operation of the electronic circuit using some of the measured electrical characteristics of the measurement capacitors or of the measurement semiconductor components;
d) selecting a type of capacitor or type of semiconductor component according to the results of the simulations; and
e) fabricating the electronic circuit with a capacitor (11) or a semiconductor component (10) of the selected type.

12. Method according to Claim 11, wherein step c) comprises the following steps:
c1) generating electrical models associated with the measurement capacitors or with the measurement semiconductor components using the measured electrical characteristics; and
c2) performing simulations using at least some of the electrical models generated.

## Patentansprüche

1. Schaltung mit einem Substrat (100), einem Kondensator (11) und wenigstens einem Halbleiterbauelement (10), das von einer Oberfläche (S) des Substrats getragen wird, wobei der Kondensator und das Halbleiterbauelement in einer Richtung (D) senkrecht zur Oberfläche (S) des Substrats im rechten Winkel zueinander angeordnet sind, bei der eine ebene, zur Oberfläche des Substrats parallele, aus einem metallischen Werkstoff gebildete Abschirmung (12) zwischen dem Kondensator und dem Halbleiterbauelement angeordnet ist,
wobei die Schaltung **dadurch gekennzeichnet ist, dass** die Abschirmung Öffnungen (12a) aufweist.

2. Schaltung nach Anspruch 1,
bei der die Ränder der Abschirmung wenigstens teilweise außerhalb einer Projektion der Ränder des Kondensators (11) in Richtung (D) senkrecht zur Oberfläche des Substrats in einer Ebene liegen, welche die Abschirmung umfasst.

3. Schaltung nach Anspruch 2,
bei der die Ränder der Abschirmung wenigstens 2 Mikrometer von der Projektion der Ränder des Kondensators entfernt in einer Richtung parallel zu der Richtung der Ebene liegen, welche die Abschirmung umfasst.

4. Schaltung nach einem der vorhergehenden Ansprüche,
bei der die Ränder der Abschirmung (12) wenigstens teilweise außerhalb einer Projektion der Ränder des Halbleiterbauelements (10) in Richtung (D) senkrecht zur Oberfläche des Substrats in einer Ebene liegen, welche die Abschirmung umfasst.

5. Schaltung nach Anspruch 4,
bei der die Ränder der Abschirmung wenigstens 2 Mikrometer von der Projektion der Ränder des Halbleiterbauelements entfernt in einer Richtung parallel zu der Richtung der Ebene liegen, welche die Abschirmung umfasst.

6. Schaltung nach einem der vorhergehenden Ansprüche,
bei der das Halbleiterbauelement (10) in der Nähe der Oberfläche (S) des Substrats (100) angeordnet ist, wobei die Schaltung mehrere übereinanderliegende Isolierstoffschichten (1-6) aufweist, welche die Oberfläche des Substrats und das Halbleiterbauelement bedecken, wobei der Kondensator in wenigstens einer Isolierstoffschicht (5) über dem Halbleiterbauelement angeordnet ist, und bei der die Abschirmung (12) in wenigstens einer Zwischenschicht (4) aus Isolierstoff zwischen der Oberfläche des Substrats und der Isolierstoffschicht angeordnet ist, in der der Kondensator angeordnet ist.

7. Schaltung nach Anspruch 6,
bei der die Isolierstoffschicht (4), in der die Abschirmung (12) angeordnet ist, an die Isolierstoffschicht (5) angrenzt, in der der Kondensator angeordnet ist.

8. Schaltung nach Anspruch 6 oder Anspruch 7,
die ferner Metallanschlüsse (14, 15) oder Widerstände (16) umfasst, die in den zusätzlichen Isolierstoffschichten (1-3) parallel zur Oberfläche (S) des Substrats angeordnet sind, bei der wenigstens die rechtwinklig zum Kondensator angeordneten Metallanschlüsse und Widerstände auf der dem Kondensator entgegengesetzten Seite der Abschirmung (12) liegen.

9. Schaltung nach einem der vorhergehenden Ansprüche,
bei der die Abschirmung (12) mit einer auf eine bestimmte elektrische Spannung gebrachten Klemme elektrisch verbunden ist.

10. Schaltung nach einem der vorhergehenden Ansprüche,
bei welcher der Werkstoff der Abschirmung (12) aus einer Materialliste gewählt ist, die Kupfer, Aluminium, Wolfram, Tantal und eine wenigstens eines der vorstehend genannten Metalle umfassende Legierung enthält.

11. Verfahren zum Entwurf einer Schaltung nach einem der Ansprüche 1 bis 10, das die folgenden Schritte umfasst:
a) Herstellen von Prototypen mit jeweils einem Substrat, einem Mess-Kondensator oder einem Mess-Halbleiterbauelement jeweils eines bestimmten Typs, wobei der Mess-Kondensator oder das Mess-Halbleiterbauelement von einer Oberfläche des Substrats getragen wird, wobei jeder Prototyp ferner eine ebene und zur Oberfläche des Substrats parallele Abschirmung aufweist, wobei die Abschirmung aus einem metallischen Werkstoff mit Öffnungen (12a) gebildet ist und rechtwinklig zu dem Mess-Kondensator oder dem Mess-Halbleiterbauelement in einer Richtung senkrecht zur Oberfläche des Substrats angeordnet ist;
b) Messen entsprechender elektrischer Eigenschaften der Mess-Kondensatoren oder der Mess-Halbleiterbauelemente innerhalb der Prototypen;
c) Durchführen von Simulationen mit Hilfe wenigstens eines Programms zum rechnergestützten Entwurf von Schaltungen, Betrieb der Schaltung durch Verwendung einiger der elektrischen Eigenschaften der Mess-Kondensatoren oder der Mess-Halbleiterbauelemente;
d) Wahl eines Kondensator- oder Halbleiterbauelementtyps in Abhängigkeit von den Simulationsergebnissen; und
e) Herstellen der Schaltung mit einem Kondensator (11) oder einem Halbleiterbauelement (10) des gewählten Typs.

12. Verfahren nach Anspruch 11, bei dem der Schritt c) die folgenden Schritte umfasst:
c1) Erzeugen von elektrischen Modellen, die unter Verwendung der gemessenen elektrischen Eigenschaften den Mess-Kondensatoren oder den Mess-Halbleiterbauelementen zugeordnet sind; und
c2) Durchführen von Simulationen unter Verwendung wenigstens einiger der erzeugten elektrischen Modelle.
